# EUROPEAN PATENT APPLICATION

(11) **EP 4 791 132 A2**
(43) Date of publication of application: **12.08.2026**
(21) Application number: 26150899.8
(22) Date of filing: 08.01.2026
(51) Int. Cl.: H05K 7/20

(54) **SERVER WITH MODULAR THERMAL MANAGEMENT**

(30) Priority: 16.01.2025 US 202563745842 P
(71) Applicant: Carrier Corporation, Palm Beach Gardens, FL 33418 (US)
(72) Inventor: JOARDAR, Arindom, Syracuse, NY, 13057 (US)
(74) Representative: Dehns

(57) **Abstract**

A cooling module (100) associable with a heat-generating electronic device (80) of a server (30) includes a casing (102) having a hollow interior (104) and at least one heat removal device (120) arranged within the hollow interior (104). A fluid flow path (124) of a primary cooling fluid (C1) extends through the casing (102) and the at least one heat removal device (120) defines a portion of the fluid flow path (124). The primary cooling fluid (C1) is configured to absorb heat from the heat-generating electronic device (80) within the cooling module (100).

## Description

### BACKGROUND

Exemplary embodiments pertain to the art of thermal management, and more particularly, relate to thermal management of a server within a data center.

A "data center" refers to the physical location of one or more servers. A data center and the servers housed within a data center typically consume a significant amount of electrical power. Existing servers are designed to be cooled at least partially by a flow of air. Such servers usually include one or more printed circuit boards having a plurality of operable heat-generating electronic devices mounted thereto. The printed circuit boards are commonly housed in an enclosure having vents configured to direct external air from the data center into, through and out of the enclosure. The air absorbs heat dissipated by the components and after being exhausting from the enclosure, mixes with the ambient air. An air conditioner is then used to cool the heated air of the data center and to recirculate it, repeating the cooling process.

Higher performance server components typically dissipate more power. However, the amount of heat that conventional cooling system can remove from a server is in part limited by the extent of the air conditioning available from the data center. In general, a lower air temperature in a data center allows each server component cooled by an air flow to dissipate a higher power, and thus allows each server to operate at a correspondingly higher level of performance.

### BRIEF DESCRIPTION

Viewed from a first aspect, there is provided a cooling module associable with a heat-generating electronic device of a server. The cooling module includes a casing having a hollow interior and at least one heat removal device arranged within the hollow interior. A fluid flow path of a primary cooling fluid extends through the casing and the at least one heat removal device defines a portion of the fluid flow path. The primary cooling fluid is configured to absorb heat from the heat-generating electronic device within the cooling module.

The cooling module may form a mechanical interface with the server and a thermal interface with the heat-generating electronic device.

The at least one heat removal device may be mountable in an overlapping arrangement with the heat-generating electronic device.

The at least one heat removal device may be directly thermally couplable to the heat-generating electronic device.

Yhe at least one heat removal device may be indirectly thermally couplable to the heat-generating electronic device and a heat spreader couples the cooling module to the heat-generating electronic device.

The heat spreader may be positionable vertically between the heat-generating electronic device and the at least one heat removal device.

The at least one heat removal device may include a heat sink.

The heat sink may be a cold plate.

The at least one heat removal device may include a heat exchanger. The primary cooling fluid may be arrangeable in a heat transfer relationship with a secondary cooling fluid at the heat exchanger.

The cooling module may include at least one inlet opening and at least one outlet opening formed in the casing and associated with a flow path of the secondary cooling fluid through the cooling module. At least one movement mechanism may be mounted within the interior of the casing. The at least one movement mechanism may be operable to move the secondary cooling fluid along the flow path.

The at least one heat removal device may include a heat sink. The heat exchanger and the heat sink may be arranged in series relative to a flow of the primary cooling fluid along the fluid flow path.

The heat exchanger may be arranged downstream from and be fluidly connected to a fluid outlet of the heat sink.

The at least one heat removal device may include a microstructure optimized to facilitate heat transfer to the primary cooling fluid.

The cooling module may include a pump for circulating the primary cooling fluid through the fluid flow path.

The cooling module may be removably mountable to the server.

Viewed from a second aspect, there is provided a server. The server includes a heat-generating electronic device and a cooling module removably mounted to the server such that the cooling module is thermally coupled to the heat-generating electronic device. The cooling module includes at least one heat removal device configured to receive a primary cooling fluid to absorb heat from the heat-generating electronic device.

The at least one heat removal device of the cooling module may be positionable in overlapping arrangement with the heat-generating electronic device.

The cooling module may form a quick connect interface with the server.

The cooling module may include a controller operable to adjust one or more parameters of the cooling module in response to a cooling demand of the heat-generating electronic device.

The at least one heat removal device may be also configured to receive a secondary cooling fluid. The controller may be operable to adjust a flow rate of at least one of the primary cooling fluid and the secondary cooling fluid in response to the cooling demand of the heat-generating electronic device.

### BRIEF DESCRIPTION OF THE DRAWINGS

The following descriptions should not be considered limiting in any way. With reference to the accompanying drawings, like elements are numbered alike:
FIG. 1 is a front view of a data center rack having a plurality of servers mounted therein;
FIG. 2A is a perspective view of a server;
FIG. 2B is a cross-sectional side view of a server;
FIG. 3 is a schematic view of a cooling module mounted to a heat-generating electronic device;
FIG. 4 is a schematic diagram of a heat sink having a fluid flow path formed therein;
FIG. 5 is a front view of a heat exchanger directly thermally couplable to a heat-generating electronic component;
FIG. 6 is a front view of a heat exchanger indirectly thermally couplable to a heat-generating electronic component;
FIG. 7 is a schematic diagram of a portion of a cooling module; and
FIG. 8 is a schematic diagram of a fluid circuit of a primary cooling fluid when a cooling module is connected to a server.

### DETAILED DESCRIPTION

A detailed description of one or more embodiments of the disclosed apparatus and method are presented herein by way of exemplification and not limitation with reference to the Figures.

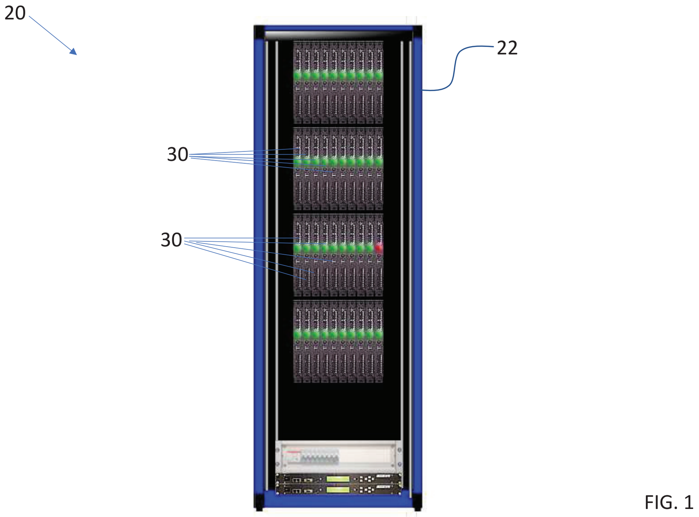

With reference now to FIG. 1, an example of a data center 20 is illustrated. As shown, the data center 20 includes a cabinet 22 having at least one, and in some embodiments, a plurality of slots (not shown) formed therein. One or more server rack sub-assemblies, also referred to herein as servers 30 may be permanently or removably mountable within the cabinet 22, such as within the one or more slots formed therein. The plurality of slots, and therefore the at least one server 30 receivable therein, may have a generally vertical orientation (shown), or alternatively, may have a horizontal orientation. In some embodiments, the data center 20 may include a combination of both horizontally oriented and vertically oriented slots. Further, although only a single cabinet 22 is illustrated in the FIG., it should be appreciated that the data center 20 may include several cabinets 22. In embodiments including a plurality of cabinets 22, the plurality of cabinets 22 may be arranged at the same location within a building, or alternatively, one or more of the cabinets 22 may be arranged at a different location within a single building or within multiple buildings.

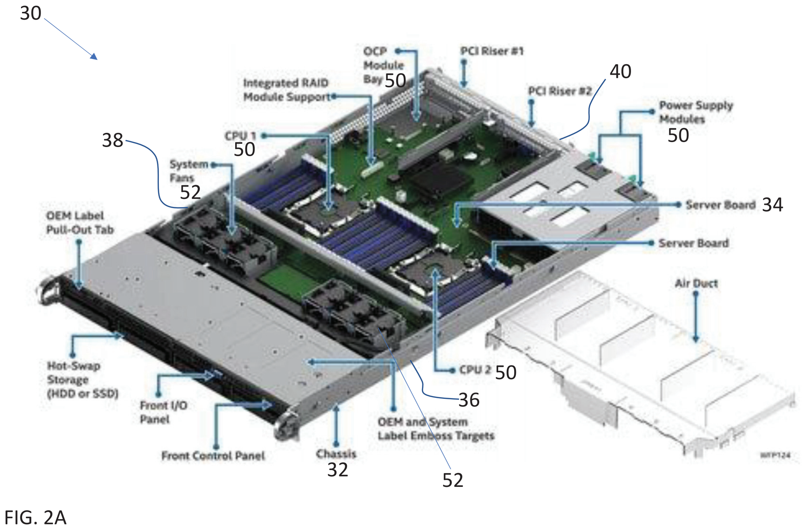

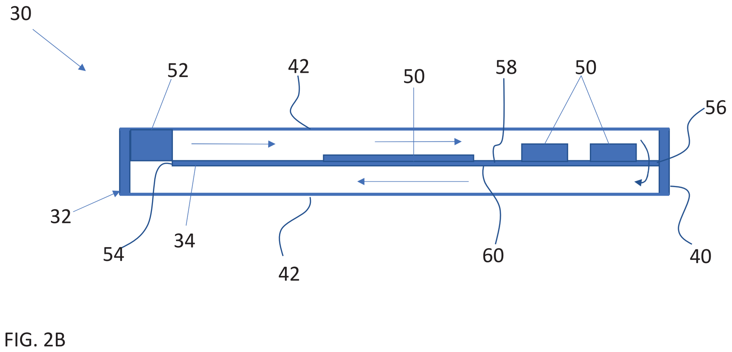

With reference now to FIG. 2, an example of a server 30 receivable within a slot of the cabinet 22 is illustrated. As shown, the server 30 may include a frame or chassis 32 having at least one printed circuit board 34 mounted to the frame. Although only a single printed circuit board 34 is illustrated in the FIG., it should be understood that in some embodiments, a plurality of printed circuit boards may be mounted to the chassis 32. The chassis 32 is designed to be insertable, for example slidably insertable, into a slot of a server rack and allow for connection to power cables, data cables, and/or other connecting cables provided at or by the cabinet 22.

The chassis 32 may include a plurality of walls 36, 38, 40 oriented at an angle to the printed circuit board 34 and that extend about all or at least a portion of a periphery of the printed circuit board 34. In an embodiment, best shown in FIG. 2B, the chassis 32 includes at least one flat, generally planar panel connected to one or more of the peripheral walls 36,38, 40 of the chassis 32. The at least one flat panel 42 may be arranged at either a first side or a second side of the printed circuit board 34. When the server 30 is in a horizontal orientation as shown, such a flat panel 42 may be vertically offset from the printed circuit board 34, either above or underneath the printed circuit board. In some embodiments, a flat panel 42 may be arranged both above and below the printed circuit board. In an embodiment, the chassis 32 in combination with the flat panels 42 form an air-tight container surrounding the server 30. However, embodiments where a separate jacket or container is positioned about the server 30 to form an air-tight assembly are also contemplated herein.

At least one heat-generating electronic device 50 may be mounted or electrically connected to the printed circuit board 34. Examples of a heat-generating electronic device 50 include but are not limited to a processor such as a central processing unit and/or graphics processing unit, memory, a hard drive, and a power supply module. A server 30 may also include one or more components that are not mounted to or are not electrically connected to the printed circuit board 34. In embodiments where the server 30 includes two or more of the same type of component, such as central processing units for example, the components may be aligned along an axis extending between the lateral sides 36, 38 of the chassis 32, may be aligned along an axis extending between the front and back of the chassis 32, or may be offset from one another in one or more directions. It should be appreciated that any heat-generating electronic device 50 may be located at any position within the chassis 32 or about the circuit board 34.

In some embodiments, one or more fluid movement devices 52, such as fans for example, are mounted to the printed circuit board 34 and are operable to move a flow of a fluid, such as air over the heat-generating electronic devices 50. In the illustrated, non-limiting embodiment, the at least one fluid movement device 52 is arranged near a first end 54 of the printed circuit board 34 such that when the server 30 is installed within the cabinet 22, the at least one fan 52 is positioned closer to the front of the cabinet 22 than the heat-generating electronic devices 50. However, embodiments where one or more fluid movement devices 52 are arranged at another suitable location, such as near a second end 56 of the printed circuit board 34 or of the chassis 32 associated with the rear of the cabinet 22 for example, are also within the scope of the disclosure. It should be appreciated that a server 30 having any suitable configuration, including servers having a full width or a half width or sled configuration are within the scope of the disclosure.

In an embodiment, the fluid moved by the at least one fluid movement device 52 is configured to make a single pass over the heat-generating electronic devices. For example, cool air may be drawn into the fan 52 from a location adjacent to the front of the chassis 32 and after removing heat from the heat-generating electronic devices 50, may be exhausted at the back of the chassis 32. It should be appreciated that the air exhausted from the back of the cabinet may be the same temperature as the surrounding or environment, warmer than the surrounding environment, or even cooler than the surrounding environment. In other embodiments, such as where the chassis 32 includes at least one flat panel 42 for example, the fluid may be configured to continuously circulate within the server 30. For example, as best shown in FIG. 2B, a fan 52 may push the flow of fluid across the heat-generating electronic devices 50 arranged at a first surface 58 of the printed circuit board 34. Upon reaching the second end 56 of the printed circuit board 34, the fluid may turn through one or more openings and make a second pass along the second, opposite side 60 of the printed circuit board 34. Upon reaching the first end 54 of the printed circuit board 34, the fluid may turn again and be drawn back into an inlet of the at least one fan 52.

The heat-generating electronic devices of a server, such as server 30 for example, typically include one or more main heat-generating electronic devices and one or more peripheral heat-generating electronic devices. Examples of a main heat-generating electronic device include microchips, such as but not limited to central processing units (CPUs) or graphics processing units (GPUs). The term "peripheral heat-generating electronic device" as used herein is intended to describe a heat-generating component that is a not a microchip. Peripheral heat-generating electronic devices may be described as other components of a server, such as a memory, hard drive, or power supply module. In an embodiment, a peripheral heat-generating electronic device generates less heat than a main heat-generating electronic device when energized. For example, a peripheral heat-generating electronic device may be configured to generate less than 25% of the heat of the server, and in some embodiments less than 20%, less than 19%, less than 18%, less than 17%, less than 16%, less than 15%, less than 14%, less than 13%, less than 12%, less than 11%, or less than 10%. However, it should be appreciated that any of the components of the server 30 may be designed as the at least one peripheral heat-generating electronic device and any of the components of the server 30 may be designed as a main heat-generating electronic device.

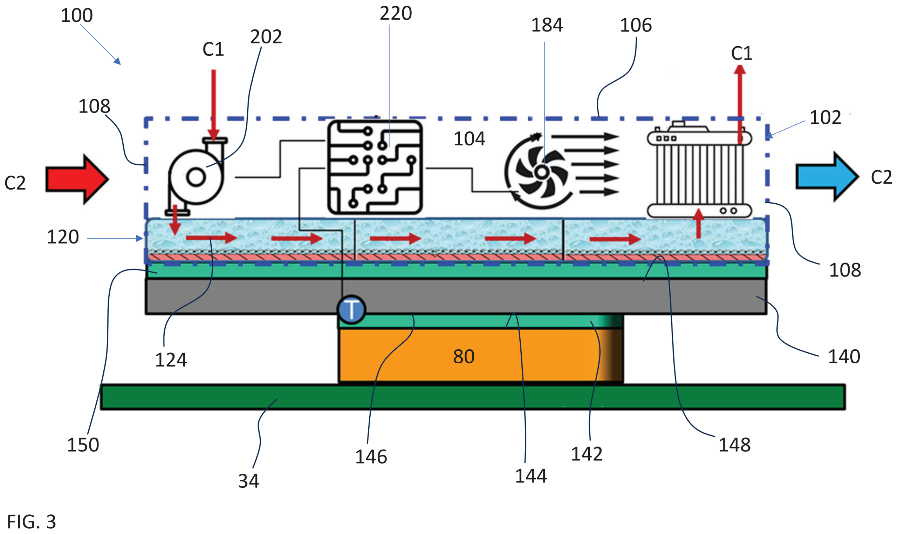

With reference now to FIG. 3-6, a cooling module 100 may be thermally coupled to a corresponding heat-generating electronic device of a server for example. In an embodiment, the cooling module 100 is thermally coupled to a heat-generating electronic device, illustrated at 80. Although the heat-generating electronic device 80 described herein is a main heat-generating electronic device, it should be appreciated that in other embodiments, the heat-generating electronic device 80 is a peripheral heat-generating electronic device. In an embodiment, the cooling module 100 additionally forms a mechanical interface with a portion of the server 30, and in some embodiments, with the heat-generating electronic device.

With continued reference to FIGS. 3-6, the cooling module 100 includes a housing or casing 102 having an interior 104 and a plurality of cooling components associated with of the casing 102. As shown, the casing 102 may have a top 106 and plurality of sides 108 extending downwardly from the top 106 to define the interior 104 of the cooling module 100. One or more heat removal devices are arranged at least partially within the interior 104 of the casing 102. In an embodiment, the casing 102 is configured to substantially encase or enclose the at least one heat removal device. The at least one heat removal device 120 may be thermally couplable to a selected heat-generating electronic device 80.

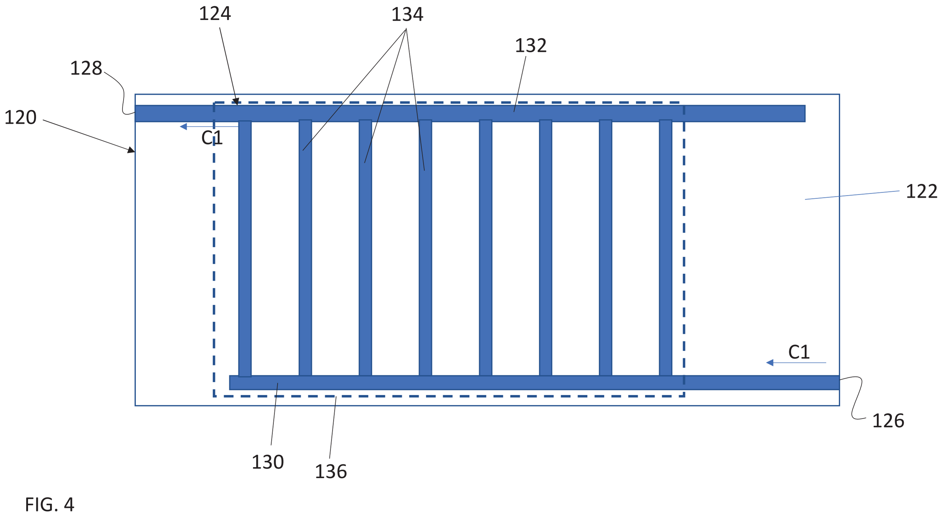

The one or more heat removal devices of the cooling module 100 may include a heat sink 120. As shown, the heat sink 120 may be positionable vertically above and/or in overlapping arrangement with the heat-generating electronic device 80. With reference to FIGS. 3 and 4, the heat sink 120 may include a body 122 having a fluid circuit or fluid flow path 124 formed therein. The fluid flow path may extend through an interior of the body 122 such that the fluid flow path is enclosed within the body 122. In an embodiment, the heat sink 120 is a cold plate. As shown, the fluid flow path 124 of the heat sink 120 includes a fluid inlet 126 and a fluid outlet 128. The fluid inlet 126 may be configured to receive a flow of the primary cooling fluid C1 from a source, such as from a heat rejection unit for example. Similarly, the fluid flow path 124 includes a fluid outlet 128 configured to output a flow of primary cooling fluid C1 from the heat sink 120. The orifice (not shown) defining the fluid inlet 126 and the fluid outlet 128 can be any shape. Also, in an embodiment, the fluid outlet 128 can have a larger diameter than the fluid inlet 126, thereby helping to reduce the pressure drop for the primary cooling fluid C1 passing through the fluid outlet 128.

In an embodiment, the fluid flow path 124 includes a single continuous flow path extending between the fluid inlet 126 and the fluid outlet 128. Such a flow path may have a tortuous or serpentine configuration that makes multiple passes between the fluid inlet 126 and fluid outlet 128. In other embodiments, the fluid circuit includes a first or inlet manifold 130, a second or outlet manifold 132, and at least one fluid passage 134 connecting the first and second manifolds 130, 132. In an embodiment, the at least one fluid passage 134 includes a plurality of fluid passages 134. The one or more fluid passages 134 of the fluid flow path 124 may be positioned to perform localized cooling at the area of the heat sink 120 with the greatest heat flux, such as at the area directly aligned with or in overlapping arrangement with a heat-generating electronic module 80, represented by 136 in FIG. 4. Accordingly, the at least one fluid passage 134 may be associated with a heat-generating electronic device 80.

As the primary cooling fluid C1 moves through the fluid flow path 124 of the heat sink 120, the primary cooling fluid C1 absorbs heat from the body 122 of the heat sink 120 which is thermally coupled to and is heated by the heat-generating electronic device 80. In an embodiment, all or at least a portion of a surface defining the fluid flow path 124 is optimized to facilitate heat transfer to the primary cooling fluid C1 within the heat sink 120. This optimization may include the formation of a specific microstructure along the fluid flow path 124. Further, his optimization may be performed via application a coating or film, or alternatively, via a machining process or another suitable manufacturing process.

In an embodiment, the heat sink 120 is directly thermally coupled to the heat-generating electronic device 80. In such embodiments, the heat sink 120 may form the bottom of the cooling module 100. However, in other embodiments, such as shown in FIG. 4, the heat sink 120 may be indirectly thermally coupled to the heat-generating electronic device 80, such as via a heat spreader 140 for example. In embodiments where the heat sink 120 is connectable to a heat-generating electronic device 80 via another component, such as a heat spreader, the heat spreader 140 may but need not be considered part of the cooling module 100. Accordingly, in an embodiment, the cooling module 100 is permanently or removably mountable to the heat spreader 140. However, in embodiments where the heat spreader 140 is part of the cooling module 100, the cooling module 100 is permanently or removably mountable to the heat-generating electronic device 80.

The heat spreader 140 may be formed from any suitable material, such as a conductive material, like sheet metal for example. The heat spreader 140 may be mountable in an axially overlapping relationship with heat-generating electronic device 80 such that the heat spreader 140 is thermally coupled to the heat-generating electronic device 80. Further, the heat spreader 140 may be mechanically connected to the heat-generating electronic device 80 and/or to the printed circuit board 34, such as at a location adjacent to the heat-generating electronic device 80. A thermal interface material 142 may be arranged between a surface 144 of the heat-generating electronic device 80 and an adjacent surface 146 of the heat spreader 140 to facilitate the transfer of heat from the heat-generating electronic device 80 to the heat spreader 140. The surface area of the surface 146 of the heat spreader 140 facing the heat-generating electronic device 80 may be greater than, equal to, or in some embodiments, may even be smaller than the surface area of the surface 144 of the heat-generating electronic device 80.

The heat sink 120 is thermally coupled to a second, opposite surface 148 of the heat spreader 140. A thermal interface material 150 may be arranged between the surface 148 of the heat spreader 140 and a surface of the heat sink 120 to facilitate the transfer of heat from the heat spreader 140 to the primary cooling fluid C1 of the heat sink 120. In an embodiment, the second, opposite surface 148 of the heat spreader 140 is greater than the surface 144 of the heat-generating electronic device 80 to facilitate the transfer of heat from the heat spreader 140 to the heat sink 120. However, in other embodiments, the surface area of the second surface 148 of the heat spreader 140 may be the same or even smaller than the area of surface 144 of the heat-generating electronic device 80.

In the illustrated, non-limiting embodiment, the cooling module 100 additionally includes another heat removal device in the form of a heat exchanger 160. A cooling module 100 including both a heat sink 120 and a heat exchanger 160 is operable to perform two different types of cooling. First, the heat-generating electronic device 80 thermally connected to the cooling module 100 is cooled via a flow of a primary cooling fluid C1 within the heat sink 120as previously described. Second, as will be described in more detail below, a secondary cooling fluid C2 may be cooled within the cooling module 100 via heat transfer with the primary cooling fluid C1. The secondary cooling fluid C2 may be cooled within the cooling module 100 to a temperature suitable to remove heat from one or more peripheral heat-generating electronic devices 82, such as located downstream from the cooling module 100 for example. The primary and secondary cooling fluids C1, C2 described herein may be the same type of fluid, or alternatively, may be distinct or different types of fluids

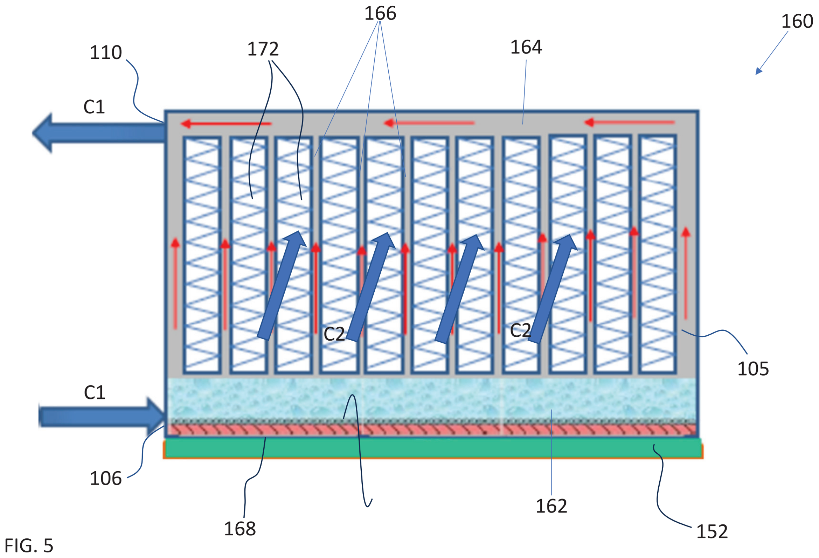

The heat exchanger 160 may be mountable in an axially overlapping relationship with and is thermally couplable to the heat-generating electronic device 80. In the illustrated, non-limiting embodiment, the heat exchanger 160 is mounted to a surface of the heat sink 120, such as a surface of the body 122 for example. In such embodiments (FIGS. 3 and 5), a thermal interface material 152 may be arranged between a surface of the heat sink 120 and a surface 168 of the inlet manifold 162 to facilitate the transfer of heat from the body 122 of the heat sink 120 spreader 140 to the primary cooling fluid C1 within the inlet manifold 162. However, embodiments where the heat exchanger 160 is located remotely from the heat sink 120 are also contemplated herein.

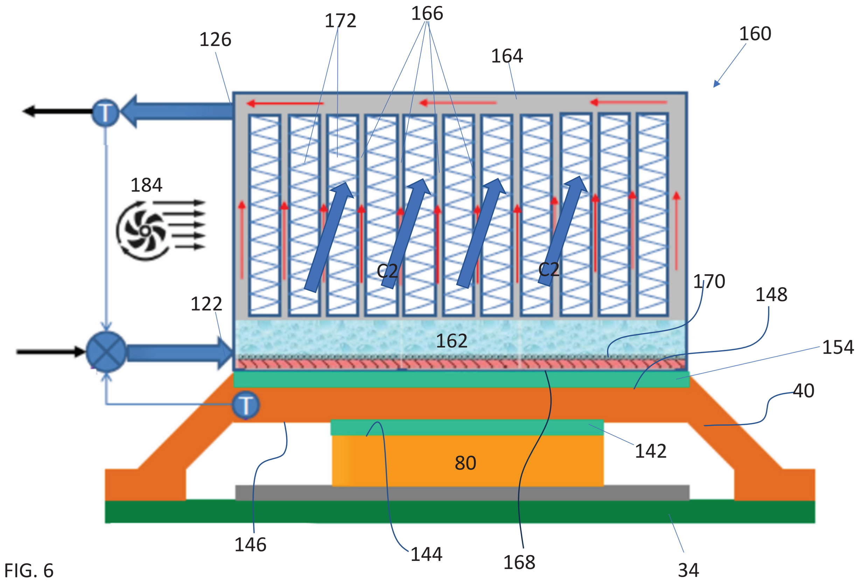

Further, it should be understood that although the heat exchanger 160 is illustrated and described herein in combination with the heat sink 120, embodiments of a cooling module 100 including a heat exchanger 160 without a heat sink 120 are also within the scope of the disclosure. In such embodiments, the heat exchanger 160 may be directly thermally coupled to the heat-generating electronic device 80. In other embodiments, such as shown in FIG. 6, the heat exchanger 160 may be indirectly thermally coupled to the heat-generating electronic device 80, such as via a heat spreader 140 for example. Accordingly, a thermal interface material 154 may be arranged between the surface 148 of the heat spreader 140 and a surface of the inlet manifold 162 to facilitate the transfer of heat from the heat spreader 140 to the primary cooling fluid C1 within the inlet manifold 162.

The body of the heat exchanger 160 includes an inlet manifold 162, an outlet manifold 164, and a plurality of heat exchanger tubes 166 fluidly connecting the inlet manifold 162 to the outlet manifold 164. The heat exchanger 160 may be a microchannel heat exchanger where each of the plurality of substantially parallel microchannel heat exchanger tubes 166 defines a plurality fluid flow paths therethrough. However, examples of other types of heat exchangers that may be used, include, but are not limited to, microtube, double pipe, shell and tube, tube and fin, plate, plate and shell, adiabatic shell, plate fin, pillow plate, and fluid heat exchangers. The type of heat exchanger 160 selected may depend at least in part based on the type of primary and secondary cooling fluids being provided thereto.

The heat exchanger 160 and the heat sink 120 may be arranged in series relative to the flow of the primary cooling fluid C1 through the cooling module. In an embodiment, the inlet manifold 160 of the heat exchanger 160 is fluidly connected to and located downstream from the fluid outlet 128 of the heat sink 120. Similarly, the outlet manifold 164 of the heat exchanger may be fluidly connected to the heat rejection unit, such as a condenser for example. The heat rejection unit may be located remotely from the

In operation, the primary cooling fluid C1, such as a refrigerant for example, is provided to the inlet manifold 162 of the heat exchanger 160. The primary cooling fluid C1 provided to the inlet manifold 162 may be a liquid, or alternatively, may be a two-phase mixture of liquid and vapor. Within the inlet manifold 162, at least a portion of the heat transferred from the heat-generating electronic device 80 is transferred to the primary cooling fluid C1. In embodiments where the heat exchanger 160 is mounted directly to the body 122 of the heat sink 120, excess heat of the body 122 that was not removed by the primary cooling fluid C1 is transferred to the primary cooling fluid C1 within the inlet manifold 162. As a result, the temperature of the primary cooling fluid C1 within the inlet manifold 162 increases, and in some embodiments, causes at least a portion of the primary cooling fluid C1 within the inlet manifold 162 to vaporize.

In an embodiment, a surface of the heat exchanger 160, such as a bottom surface 168 of the inlet manifold 162 for example, is optimized to facilitate boiling of the primary cooling fluid C1 within the inlet manifold 162. This optimization may include the formation of a specific microstructure 170 at the surface 168. In an embodiment, this optimization is performed via application a coating or film applied to the surface 168. Alternatively, this optimization may be performed via a machining process or another suitable manufacturing process.

The primary cooling fluid C1 and a secondary cooling fluid C2 are arranged in a heat exchange relationship at the heat exchanger 160. The heat exchanger 160 may be configured as an evaporator such that the primary cooling fluid C1 is configured to absorb heat from the secondary cooling fluid C2. In the illustrated, non-limiting embodiment, the secondary cooling fluid C2 is a flow of air. However, it should be understood that any fluid, including a liquid, may be used as the secondary cooling fluid C2. In the non-limiting embodiment illustrated, the heat exchanger 160 has a single pass configuration for both the primary cooling fluid C1 and the secondary cooling fluid C2. However, in other embodiments, at least one of the primary and secondary cooling fluids C1, C2 may make multiple passes through the heat exchanger 160. Further, the primary and secondary cooling fluids C1, C2 may be arranged in any suitable flow configuration at the heat exchanger 160, such as a cross-flow, a parallel flow, a counter-flow, or any combination thereof.

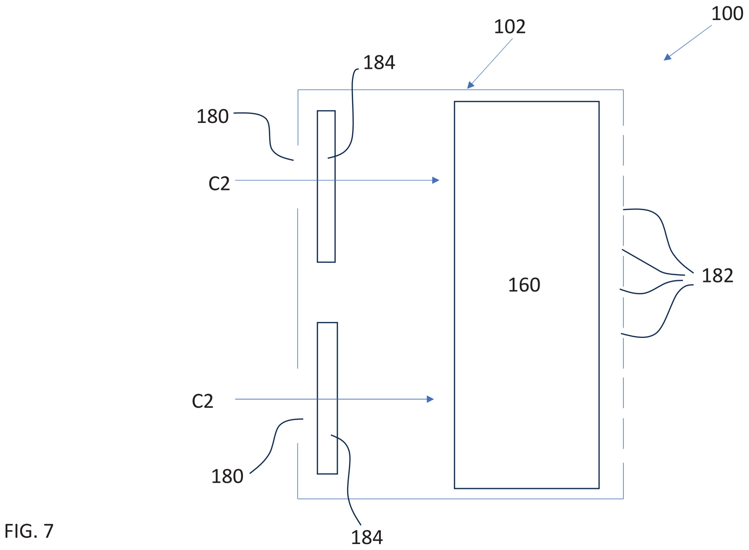

In an embodiment, one or more openings or gaps are formed at various locations of the casing 102. At least one inlet opening 180 may be arranged upstream from the heat exchanger 160 and at least one opening 182 may be arranged downstream from the heat exchanger 160. For example, as best shown in FIG. 7, one or more inlet openings 180 may be arranged at a first upstream end of the casing 102 relative to a flow of a second cooling fluid C2 and one or more outlet openings 182 are formed at a downstream end of the casing 102 relative to a flow of a second cooling fluid C2. Accordingly, the one or more inlet openings and the at least one outlet opening in combination define a flow path of the second medium through the interior 104 of the casing 102. In an embodiment, the cooling module 100 includes at least one movement mechanism 184, such as a fan for example, to draw or push a flow of the second cooling fluid C2 through the cooling module 100.

As the primary cooling fluid C1 at least partially vaporizes within the inlet manifold 162, the gaseous primary cooling fluid C1 having some liquid primary cooling fluid entrained therein is configured to flow through the plurality of heat exchange tubes 166 of the heat exchanger 160 toward the outlet manifold 164 of the heat exchanger 160. In the illustrated, non-limiting embodiment, the secondary cooling fluid C2 is drawn through the one or more inlet openings 180 formed in the casing 102, and over a surface of the heat sink 120 upstream from the heat exchanger 160. In an embodiment, the region of the heat sink 120 upstream from the heat exchanger 160 includes one or more fins protruding outwardly from the body 122, such as generally upwardly for example. In such embodiments, the cool secondary cooling fluid C2 is configured to flow through the fins and absorb heat from the heat sink 120 via this interface.

The secondary cooling fluid C2 is then configured to flow through the gaps 172 defined between adjacent heat exchanger tubes 166 of the heat exchanger 160. Within the plurality of passages of the heat exchange tubes 166, heat from the secondary cooling fluid C2 is transferred to the primary cooling fluid C1, causing at least some of the liquid primary cooling fluid C1 to vaporize. The resulting cooled secondary cooling fluid C2 output from the heat exchanger 160 may be output from the cooling module 100 via one or more outlet openings 182 formed in the casing so as to flow over the peripheral heat-generating electronic devices of the server 30. The heated primary cooling fluid C1 received within the outlet manifold 164 may then be delivered to a heat rejecting unit. In an embodiment, the heat rejection unit includes one or more downstream loads. The heated primary cooling fluid C1 provided at an outlet of the outlet manifold 164 may include a greater amount of vapor than the primary cooling fluid C1 provided to the inlet manifold 162. In an embodiment, the primary cooling fluid C1 provided to the inlet manifold 162 is primarily vapor, if not entirely vapor.

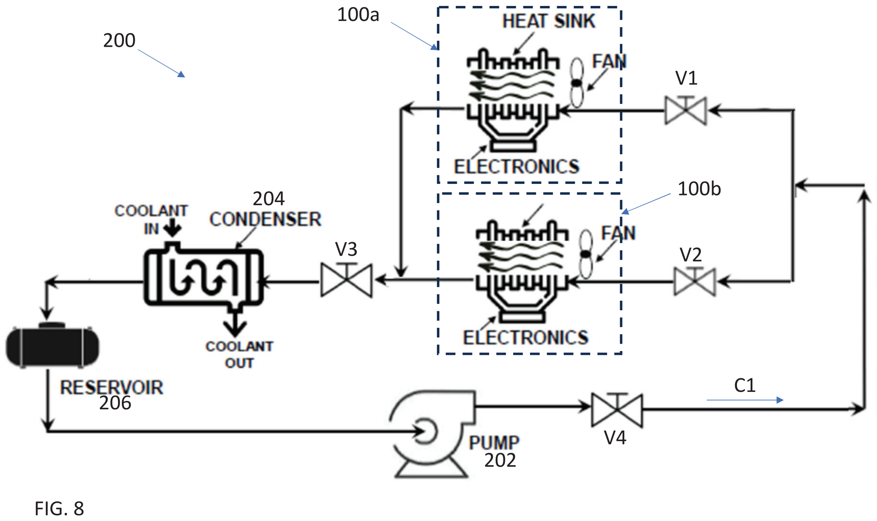

An example of a circuit 200 of the primary cooling fluid C1 associated with a server is illustrated in FIG. 8. The circuit 200 of the primary cooling fluid C1 may include a pump 202 or other movement mechanism for moving a primary cooling fluid C1 through the circuit. In addition, the circuit 200 may include a heat rejection or cooling heat exchanger 204 configured to remove heat from the primary cooling fluid C1. Further, a reservoir or accumulator 206 may be operable to store excess primary cooling fluid C1. In the illustrated, non-limiting embodiment, when a cooling module 100 is not fluidly connected to the circuit, the circuit 200 is not complete. As a result, the primary cooling fluid C1 may not flow through the circuit 200 when a cooing module 100 is not connected thereto.

As shown, at least one cooling module 100 is connectable to the circuit 200, such as at a location downstream from the pump 202 and upstream from the heat rejection unit 204. In the illustrated, non-limiting embodiment, the circuit 200 includes a plurality of cooling modules fluidly coupled thereto. For example, a first cooling module 100a may be mounted adjacent to a first heat-generating electronic device and a second cooling module 100b may be mounted adjacent to a second heat-generating electronic device of a server. In embodiments including a plurality of cooling modules 100a, 100b, the primary cooling fluid C1 may be provided to the plurality of cooling modules in parallel. As shown, the circuit 200 may include a plurality of valves, such as arranged directly upstream from each cooling module 100a, 100b, directly upstream from the heat rejection unit 204, and downstream from the pump 202. Operation of the valves may be used to control the flow of the primary cooling fluid C1 through the circuit 200. Although the illustrated non-limiting embodiment includes a plurality of cooling modules 100a, 100b, each associated with a respective heat-generating electronic device, in some embodiments, the circuit 200 may include a single cooling module or more than two cooling modules. Further, a cooling module 100 may be thermally couplable to a single heat-generating electronic device 80 as described herein, or alternatively, may be thermally couplable to a plurality of heat-generating electronic devices 80.

Although the pump 202 is illustrated as being separate from a cooling module in FIG. 8, in an embodiment, such as shown in FIG. 3, the pump 202 may be integrated into the cooling module 100. Alternatively, or in addition, a valve, such as the valve V 1, V2 illustrated as being arranged upstream from the cooling modules 100a, 100b may be integrated into the cooling module 100, such as at or proximate a fluid inlet of the heat sink 120 or the heat exchanger 160 for example. Further, a controller 220 operably coupled to the movement mechanism 184 and/or the valve V1/V2 may be integrated into the cooling module 100 such that the cooling module is a fully integrated stand-alone module.

In an embodiment, the controller 220 is operable to control one or more operational parameters of the cooling module 100 based on the cooling demand of the heat-generating electronic device 80 in real time. In an embodiment, the cooling module 100 includes at least one sensor operably coupled to the controller 220. The at least one sensor may include a plurality of sensors and may be used to monitor one or more of a temperature of the heat-generating electronic device 80, a temperature of the casing 102, and a temperature of the cooling fluid C2 at an outlet of the cooling module or at an outlet of the server 30. In an embodiment, the controller 229 is operable to modulate an operational speed of the pump 202, and therefore the flow rate of the primary cooling fluid C1, based on the temperature at the casing 202 and the temperature of the heat-generating electronic device 80. Alternatively, or in addition, the controller 220 may be operable to adjust the speed of the movement mechanism 184, and therefore the flow rate of the secondary cooling fluid C2, to control a temperature of the secondary cooling fluid C2 at the outlet of the server 30.

A cooling module 100 as illustrated and described herein provides an easily scalable solution for cooling heat-generating components. Such a cooling module can improve the sustainability and efficiency of the heat-generating components by rejecting the heat absorbed from the heat-generating component to a downstream heating application. In addition, the air conditioning load for cooling an area containing a data center is reduced. The cooling module 100 may have a reduced cost compared to existing single phase liquid cooling systems. Further, a cooling module packages one or more heat removal devices and the corresponding components associated therewith into a singular housing to allow for easy installation, disassembly, and replacement thereof when required. Further, such a cooling module may have mechanical, electrical, and/or fluid interfaces integrated therein as necessary to allow for quick connect and disconnect functionality of a cooling module relative to a circuit of one or more cooling fluids.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present invention has been described with reference to an exemplary embodiment or embodiments, it will be understood by those skilled in the art that various changes may be made and equivalents may be substituted for elements thereof without departing from the scope of the present invention as defined by the appended claims. In addition, many modifications may be made to adapt a particular situation or material to the teachings of the present invention without departing from the essential scope thereof. Therefore, it is intended that the present invention not be limited to the particular embodiment disclosed as the best mode contemplated for carrying out this present invention, but that the present invention will include all embodiments falling within the scope of the claims.

## Claims

1. A cooling module associable with a heat-generating electronic device of a server, the cooling module comprising:
a casing having a hollow interior;
at least one heat removal device arranged within the hollow interior; and
a fluid flow path of a primary cooling fluid extending through the casing, the at least one heat removal device defining a portion of the fluid flow path, wherein the primary cooling fluid is configured to absorb heat from the heat-generating electronic device within the cooling module.

2. The cooling module of claim 1, wherein the cooling module forms a mechanical interface with the server and a thermal interface with the heat-generating electronic device.

3. The cooling module of claim 1 or 2, wherein the at least one heat removal device is mountable in an overlapping arrangement with the heat-generating electronic device.

4. The cooling module of any of claims 1-3, wherein the at least one heat removal device is directly thermally couplable to the heat-generating electronic device.

5. The cooling module of any of claims 1-3, wherein the at least one heat removal device is indirectly thermally couplable to the heat-generating electronic device and a heat spreader couples the cooling module to the heat-generating electronic device;
optionally wherein the heat spreader is positionable vertically between the heat-generating electronic device and the at least one heat removal device.

6. The cooling module of any of the preceding claims, wherein the at least one heat removal device includes a heat sink;
optionally wherein the heat sink is a cold plate.

7. The cooling module of any of the preceding claims, wherein the at least one heat removal device includes a heat exchanger, the primary cooling fluid being arrangeable in a heat transfer relationship with a secondary cooling fluid at the heat exchanger.

8. The cooling module of claim 7, further comprising:
at least one inlet opening and at least one outlet opening formed in the casing and associated with a flow path of the secondary cooling fluid through the cooling module; and
at least one movement mechanism mounted within the interior of the casing, the at least one movement mechanism being operable to move the secondary cooling fluid along the flow path.

9. The cooling module of claim 7 or 8, wherein the at least one heat removal device comprises a heat sink, the heat exchanger and the heat sink being arranged in series relative to a flow of the primary cooling fluid along the fluid flow path;
optionally wherein the heat exchanger is arranged downstream from and is fluidly connected to a fluid outlet of the heat sink.

10. The cooling module of any preceding of the claims, wherein the at least one heat removal device includes a microstructure optimized to facilitate heat transfer to the primary cooling fluid.

11. The cooling module of any of the preceding claims, further comprising a pump for circulating the primary cooling fluid through the fluid flow path.

12. The cooling module of any of the preceding claims, wherein the cooling module is removably mountable to the server.

13. A server comprising:
a heat-generating electronic device; and
a cooling module removably mounted to the server such that the cooling module is thermally coupled to the heat-generating electronic device, wherein the cooling module includes at least one heat removal device configured to receive a primary cooling fluid to absorb heat from the heat-generating electronic device.

14. The server of claim 14, wherein the at least one heat removal device of the cooling module is positionable in overlapping arrangement with the heat-generating electronic device;
and/or
wherein the cooling module forms a quick connect interface with the server.

15. The server of claim 13 or 14, wherein the cooling module further comprises a controller, the controller being operable to adjust one or more parameters of the cooling module in response to a cooling demand of the heat-generating electronic device;
optionally wherein the at least one heat removal device is configured to receive a secondary cooling fluid, and the controller is operable to adjust a flow rate of at least one of the primary cooling fluid and the secondary cooling fluid in response to the cooling demand of the heat-generating electronic device.
